# EUROPÄISCHE PATENTSCHRIFT

(11) **EP 1 344 442 B1**
(45) Veröffentlichungstag und Bekanntmachung des Hinweises auf die Patenterteilung: **14.07.2004**
(21) Anmeldenummer: 01995570.7
(22) Anmeldetag: 05.12.2001
(51) Int. Cl.: H05K 13/04

(54) **BESTÜCKKOPF UND BESTÜCKSYSTEM FÜR EINE BESTÜCKVORRICHTUNG ZUM BESTÜCKEN VON BAUELEMENTEN**
PICK-AND-PLACE HEAD AND PICK-AND-PLACE DEVICE FOR PLACING COMPONENTS
TETE DE POSE DE COMPOSANTS ET SYSTEME DE POSE DE COMPOSANTS POUR DISPOSITIF A POSER DES COMPOSANTS

(30) Priorität: 21.12.2000 DE 10064108
(43) Veröffentlichungstag der Anmeldung: 17.09.2003
(73) Patentinhaber: SIEMENS AKTIENGESELLSCHAFT, 80333 München (DE)
(72) Erfinder: MEHDIANPOUR, Mohammad, 81829 München (DE)
(86) Internationale Anmeldenummer: PCT/DE2001/004558
(87) Internationale Veröffentlichungsnummer: WO 2002/051230

(56) Entgegenhaltungen:
- US-A- 5 862 586
- US-A- 6 101 709
- US-A- 6 145 901

## Beschreibung

Die Erfindung betrifft ein Bestücksystem für eine Bestückvorrichtung zum Bestücken von Bauelementen in einer Bestückebene, welcher mindestens einen Greifer zum Aufnehmen und/oder Absetzen der Bauelemente aufweist.

Bei herkömmlichen Bestückautomaten, welche eine Mehrzahl von Bestückköpfen aufweisen, die jeweils von unterschiedlichen Seiten einer Bestückebene aus die Bestückebene mit Bauelementen bestücken, besteht das Problem, dass die Bestückköpfe die Bestückebene nicht gleichzeitig bestücken können. Dies resultiert aus einer Kollisionsgefahr von gleichzeitig bestückenden Bestückköpfen, welche immer dann besteht, wenn die Bestückköpfe einander überlappende Bewegungsbereiche aufweisen. Bisher wurde versucht, dieses Problem zu lösen, indem die Bestückköpfe nur nacheinander zum Bestücken der Bestückebene verwendet wurden. Hierbei wird beispielsweise mit einem Bestückkopf die Bestückebene bestückt, während mit einem anderen Bestückkopf Bauelemente von einer Zuführeinrichtung aufgenommen werden. Hierbei ist jedoch die Bestückleistung des Bestückautomaten im Wesentlichen von der Bestückleistung eines einzigen Bestückkopfs abhängig und somit stark eingeschränkt.

Ein solcher Bestückautomat wird in US-A-5 862 586 offenbart.

Der Erfindung liegt die Aufgabe zugrunde, ein Bestücksystem anzugeben, mittels welchen ein schnelleres, flexibleres und sichereres Bestücken möglich ist.

Diese Aufgabe wird gelöst durch ein Bestücksystem mit den Merkmalen nach Anspruch 1 . Bevorzugte Ausgestaltungen der Erfindung sind in den abhängigen Ansprüchen beansprucht.

Erfindungsgemäß wird ein Bestücksystem mit mindestens zwei länglichen Trägern geschaffen, von welchen jeweils ein Bestückkopf nach der Erfindung in jeweils einem ersten Bewegungsbereich bewegbar geführt ist. Die Träger sind dabei einander über der Bestückebene zugewandt angeordnet. Durch die erfindungsgemäße Ausgestaltung der Bestückköpfe ist es möglich, diese innerhalb des jeweiligen ersten Bewegungsbereiches simultan zu verfahren, so dass von den Bestückköpfen die Bestückebene in den ersten Bewegungsbereichen simultan bestückbar ist. Da erfindungsgemäß die Bestückköpfe derart ausgebildet sind, dass die Greifer in der Bestückstellung des jeweiligen Bestückkopfes unmittelbar im Randbereich des Bestückkopfes und im Wesentlichen nicht von diesem vorragend angeordnet sind, können mehrere Bestückköpfe derart aufeinander zu bewegt werden, dass sie sich innerhalb ihres ersten Bewegungsbereiches nicht berühren können, jedoch der verbleibende Bewegungsbereich über der Bestückebene, welcher von den jeweiligen ersten Bewegungsbereichen nicht bedeckt wird, sehr klein ist. Insbesondere können die Bestückköpfe bis auf einen zweiten Bewegungsbereich, welcher in seiner Breite im Wesentlichen dem Durchmesser eines Greifers entspricht, die Bestükkebene gleichzeitig und unabhängig von einander bestücken. Der zweite Bewegungsbereich, welcher in seiner Breite im Wesentlichen dem Durchmesser eines Greifers entspricht, muss sequentiell von den Bestückköpfen bestückt werden, um mögliche Kollisionen der Bestückköpfe miteinander auszuschließen.

Erfindungsgemäß wird ein Bestücksystem, welches mit dem erfindungsgemäßen Bestückkopf versehen ist, bereitgestellt, bei welchem ein Greifer in einem Randbereich des Bestückkopfes angebracht ist, so dass er beispielsweise bündig mit dem Randbereich des Bestückkopfes abschließt oder lediglich geringfügig von diesem Randbereich über den Bestückkopf hinaus vorragt.

Mit einem derartigen Bestücksystem kann in einer Bestückebene eines Bestückautomaten, an welcher zu der Bestückebene vertikale Begrenzungsflächen vorhanden sind, bis auf einen Restbereich, welcher in seiner Breite dem halben Durchmesser eines Greifers des Bestückkopfes entspricht, die gesamte Bestückebene bestückt werden. Der Restbereich ist dabei der Bereich, welcher auf der Bestückebene zwischen der vertikalen Begrenzungsfläche, welche sich direkt an die Bestückebene anschließt, und dem Bereich ergibt, welcher mittels dem erfindungsgemäßen Bestückkopf bestückt werden kann.

Werden mehrere Bestückköpfe in einem Bestücksystem verwendet, so besteht eine vertikale Begrenzungsfläche beispielsweise in den Grenzen des Bewegungsbereiches eines der beiden Bestückköpfe. Der jeweils andere Bestückkopf darf die Grenzen dieses Bewegungsbereiches nicht überschreiten, da sonst Kollisionsgefahr mit dem anderen Bestückkopf besteht. Da erfindungsgemäß die Greifer an den Bestückköpfen in einem jeweiligen Randbereich des Bestückkopfes mit diesem abschließend oder von diesem Randbereich geringfügig vorragend angeordnet sind, entspricht jener Bewegungsbereich, welcher bei einem gleichzeitigen und unabhängigen Betrieb beider Bestückköpfe nicht benutzt werden kann, um Kollisionen zu vermeiden, einem Bewegungsbereich, welcher in seiner Breite im Wesentlichen dem Durchmesser eines Greifers entspricht. Dieser zweite Bewegungsbereich kann von den Bestückköpfen lediglich sequentiell bestückt werden.

Durch das erfindungsgemäß mögliche gleichzeitige Bestücken mit beispielsweise zwei oder mehreren Bestückköpfen werden die Schwingungen in dem Bestücksystem minimiert, da gleichzeitig einander entsprechende Bewegungen in entgegengesetzten Richtungen durchgeführt werden können. Bei einer Anordnung von mehreren Leiterplatten nebeneinander auf der Bestückebene ist es möglich, ohne Einschränkungen gleichzeitig und unabhängig zu bestücken, da der zweite Bewegungsbereich, in welchem die Bestückköpfe sequentiell arbeiten müssten, beispielsweise bei zwei nebeneinander angeordneten Leiterplatten von dem Transportmechanismus zwischen den Leiterplatten belegt ist, auf welchem nicht bestückt wird.

Die Erfindung wird unter Bezugnahme auf die Zeichnung anhand einer bevorzugten Ausführungsform näher erläutert. In der Zeichnung zeigen:
Figur 1 eine schematische Seitenansicht auf eine bevorzugte Ausführungsform nach der Erfindung, und
Figur 2 eine schematische Draufsicht auf die bevorzugte Ausführungsform nach der Erfindung.

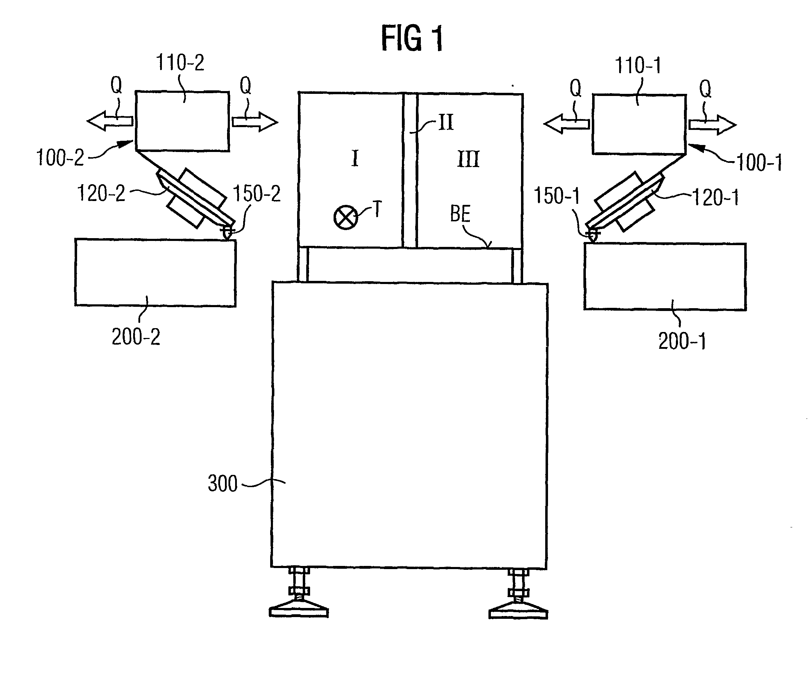

Aus der Figur 1 ist eine seitliche schematische Ansicht einer bevorzugten Ausführungsform der Erfindung ersichtlich. Auf einem Sockel 300 befindet sich eine Bestückebene BE. Die Bestückebene BE kann beispielsweise die Oberfläche von Leiterplatten sein, welche bestückt werden sollen. Diese Leiterplatten können beispielsweise mittels eines Transportmechanismus über den Sockel 300 transportiert werden. Hierbei kann die Breite der Leiterplatten derart bemessen sein, dass eine Leiterplatte in ihrer Breite der Breite der Bestückebene BE entspricht oder es können mehrere Leiterplatten mittels unabhängiger Transportmechanismen neben einander über den Sockel 300 transportiert werden.

Über der Bestückebene BE sind zwei erste Bewegungsbereiche I und III sowie ein zweiter Bewegungsbereich II ersichtlich. Seitlich der Bestückebene ist jeweils ein an einem Träger 110-1 bzw. 110-2 angeordneter Bestückkopf 100-1 bzw. 100-2 gezeigt, welcher jeweils mit einem rotationssymmetrischen Halter 120-1 bzw. 120-2 zum Aufnehmen von Greifern 150-1 bzw. 150-2 versehen ist.

Der Bestückkopf 100-1 bzw. 100-2 ist dabei an dem Träger 110-1 bzw. 110-2 in Transportrichtung T der Transportmechanismen (nicht gezeigt) über der Bestückebene verfahrbar. Außerdem ist der Träger 110-1 bzw. 110-2 in Richtung quer zu der Transportrichtung T über der Bestückebene verfahrbar, wie durch die Pfeile Q in der Figur 1 angedeutet.

Der Greifer 150-1 bzw. 150-2 ist derart an dem rotationssymmetrischen Halter 120-1 bzw. 120-2 angeordnet, dass in einer Bestückstellung, in welcher der Greifer 150-1 bzw. 150-2 ein Bestückelement von einer schematisch gezeigten Zuführeinrichtung 200-1 bzw. 200-2 aufnehmen oder ein aufgenommenes Bauelement auf der Bestückebene BE absetzen kann, der Greifer 150-1 bzw. 150-2 quer zu der Transportrichtung T zu dem jeweils anderen Bestückkopf 100-2 bzw. 100-1 hin nicht oder nicht wesentlich vorsteht. Ferner können die Bestückköpfe 100-1 und 100-2 in den ersten Bewegungsbereichen nur soweit aufeinander zu bewegt werden, dass sie sich nicht berühren können.

Dadurch ist es möglich, in den jeweiligen ersten Bewegungsbereichen I des Bestückkopfes 100-1 bzw. 100-2 simultan und unabhängig voneinander zu bestücken, da zwischen den beiden ersten Bestückbereichen I und III ein zweiter Bewegungsbereich II verbleibt, dessen Grenzen von keinem der Bestückköpfe 100-1 bzw. 100-2 soweit überschritten werden, dass es zu einer Kollision der Bestückköpfe 100-1 und 100-2 kommen kann.

Somit kann in den Bewegungsbereichen I und III mit den Bestückköpfen 100-1 bzw. 100-2 unabhängig voneinander und gleichzeitig bestückt werden, ohne dass die Gefahr einer Kollision der Bestückköpfe 100-1 und 100-2 besteht.

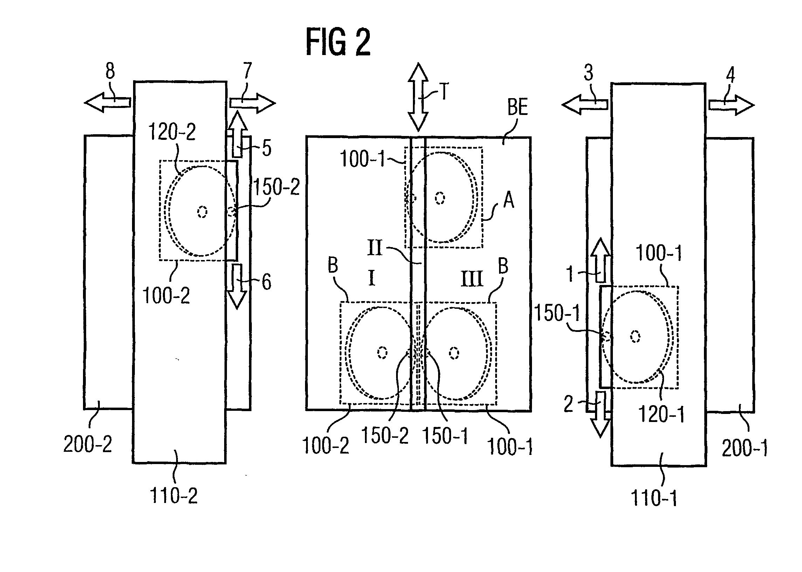

Aus Figur 2 ist eine schematische Draufsicht auf die bevorzugte Ausführungsform der Erfindung ersichtlich. Zusätzlich sind die Bestückköpfe 100-1 bzw. 100-2 jeweils in Projektion auf die Bestückebene an zwei Positionen A und B gezeigt. Die Bestückköpfe 100-1 und 100-2 sind entlang der Träger 110-1 bzw. 110-2 in der Transportrichtung T der Leiterplatten (nicht gezeigt) über der Bestückebene verfahrbar, wie durch die Pfeile 1 und 2 bzw. 5 und 6 bezeichnet. Außerdem sind die Bestückköpfe 100-1 bzw. 100-2 quer zu der Transportrichtung T verfahrbar, wie durch die Pfeile 3 und 4 bzw. 7 und 8 bezeichnet. Daraus resultiert für die Bestückköpfe 100-1 und 100-2 Bewegungsfreiheit in zwei Dimensionen parallel zu der Bestückebene BE.

Über der Bestückebene BE sind drei Bewegungsbereiche I, II und III der Bestückköpfe eingezeichnet. Die Bewegungsbereiche I und III entsprechen den Bewegungsbereichen, in welchem die Bestückköpfe 100-1 bzw.100-2 simultan und unabhängig voneinander bewegt werden können und somit simultan und unabhängig voneinander bestücken können. Dies ist schematisch aus der Projektion der Bestückköpfe 100-1 und 100-2 in der Position B in Figur 2 ersichtlich. Beim simultanen und unabhängigen Bestücken werden die Bestückköpfe 100-1 und 100-2 nur so weit quer zu der Bestückebene BE aufeinander zu bewegt, dass noch ein geringer Mindestabstand zwischen den in Richtung quer zur Transportrichtung T einander zugewandten Greifern 150-1 und 150-2 der beiden Bestückköpfe 100-1 bzw. 100-2 verbleibt.

Außerdem ist noch eine Projektion des Bestückkopfs 100-1 exemplarisch in einer Position A gezeigt, in welcher der Bestückkopf 100-1 ein Bauelement in dem zweiten Bewegungsbereich II der Bestückebene BE bestücken kann. Ein Bestücken innerhalb des zweiten Bewegungsbereiches II mit mehreren Bestückköpfen ist jedoch nur sequentiell möglich, um die Gefahr einer Kollision der Bestückköpfe auszuschließen. Daher erfolgt erfindungsgemäß das Bestücken in den ersten Bewegungsbereichen I und III sowie das Bestücken in dem zweiten Bewegungsbereich II zeitlich getrennt voneinander. D.h. es kann entweder simultan mit mehreren Bestückköpfen in den ersten Bewegungsbereichen I und III bestückt werden oder, zeitlich getrennt von dem simultanen Bestücken, mit mehreren Bestückköpfen sequentiell in dem zweiten Bewegungsbereich II bestückt werden.

## Patentansprüche

1. Bestücksystem zum Bestücken von Bauelementen in einer Bestückebene mit mindestens zwei länglichen Trägern (110-1, 110-2), an welchen jeweils ein Bestückkopf (100-1, 100-2) in jeweils einem ersten Bewegungsbereich (I, III) bewegbar geführt ist und welche Träger (110-1, 110-2) einander über der Bestückebene (BE) zugewandt angeordnet sind, wobei jeder Bestückkopf mindestens einen Greifer (150-1, 150-2) zum Aufnehmen und/oder Absetzen der Bauelemente in einer Bestückstellung des Bestückkopfs (100-1, 100-2) aufweist, und wobei der Greifer in einem Randbereich des Bestückkopfs (100-1, 100-2) derart angebracht ist, daß bei einer Projektion des Bestückkopfs (100-1, 100-2) auf die Bestückebene (BE) das Abbild des in der Bestückstellung befindlichen Greifers (150-1, 150-2) nicht von dem Abbild des Bestückkopfs (100-1, 100-2) vorragt, wobei die Bestückköpfe (100-1, 100-2) simultan bis an die Grenze ihres jeweiligen ersten Bewegungsbereichs (I, III) verfahrbar sind, so daß von den Bestückköpfen (100-1, 100-2) die Bestückebene (BE) ohne Kollisionsgefahr in den ersten Bewegungsbereichen (I, III) im Betrieb simultan bestückbar ist,
**dadurch gekennzeichnet, dass** angrenzend an die ersten Bewegungsbereiche (I, III) der Bestückköpfe (100-1, 100-2) ein zweiter Bewegungsbereich (II) vorgesehen ist, dessen Breite dem Durchmesser eines Greifers (150-1, 150-2) entspricht, und in welchem die Bestückebene (BE) von den Bestückköpfen (100-1, 100-2) im Betrieb sequentiell bestückbar ist, und wobei die ersten Bewegungsbereiche (I, III) zusammen mit dem zweiten Bewegungsbereich (II) die Bestückebene (BE) ganzflächig bedecken.

2. Bestücksystem nach Anspruch 1, wobei der zweite Bewegungsbereich (II) zwischen den ersten Bewegungsbereichen (I, III) angeordnet ist.

3. Bestücksystem nach Anspruch 2, wobei die Greifer (150-1, 150-2) an dem Bestückkopf (100-1, 100-2) grundsätzlich rotationssymmetrisch angeordnet sind und die Rotationsachse der rotationssymmetrisch angeordneten Greifer (150-1, 150-2) zu der Bestückebene (BE)' des Bestückautomaten schräg steht.

4. Bestücksystem nach Anspruch 2 oder 3,
**dadurch gekennzeichnet,**
**daß** der Bestückkopf (100-1, 100-2) revolverkopfartig ausgebildet ist.

## Claims

1. Placement system for placing components in a placement plane having at least two elongate supports (110-1, 110-2), on which a respective placement head (100-1, 100-2) is guided moveably in a respective first movement region (I, III), and which supports (110-1, 110-2) are arranged facing one another above the placement plane (BE), each placement head having at least one gripper (150-1, 150-2) for picking up and/or putting down the components in a placement position of the placement head (100-1, 100-2), and the gripper being fitted in an edge region of the placement head (100-1, 100-2) in such a way that, in the case of a projection of the placement head (100-1, 100-2) on to the placement plane (BE), the image of the gripper (150-1, 150-2) situated in the placement position does not project from the image of the placement head (100-1, 100-2), it being possible for the placement heads (100-1, 100-2) to be moved simultaneously up to the limit of their respective first movement region (I, III), with the result that the placement plane (BE) can be simultaneously populated, during operation, in the first movement regions (I, III) by the placement heads (100-1, 100-2) with no risk of collision,
**characterized in that** a second movement region (II) is provided in a manner adjoining the first movement regions (I, III) of the placement heads (100-1, 100-2), the width of which second movement region corresponds to the diameter of a gripper (150-1, 150-2), and in which second movement region the placement plane (BE) can be sequentially populated, during operation, by the placement heads (100-1, 100-2), and the first movement regions (I, III), together with the second movement region (II), covering the whole area of the placement plane (BE).

2. Placement system according to Claim 1, the second movement region (II) being arranged between the first movement regions (I, III).

3. Placement system according to Claim 2, the grippers (150-1, 150-2) being arranged on the placement head (100-1, 100-2) basically in a rotationally symmetrical manner and the axis of rotation of the grippers (150-1, 150-2) that are arranged in a rotationally symmetrical manner being at an inclination with respect to the placement plane (BE) of the automatic placement machine.

4. Placement system according to Claim 2 or 3,
**characterized in that** the placement head (100-1, 100-2) is designed like a turret head.

## Revendications

1. Système de pose pour la pose de composants dans un plan de pose, comprenant au moins deux consoles allongées (110-1, 110-2) sur lesquelles une tête de pose (100-1, 100-2) est respectivement guidée de manière mobile dans une première plage de mouvement (I, III) respective, lesdites consoles (110-1, 110-2) étant situées face à face au-dessus du plan de pose (BE), chaque tête de pose présentant au moins un préhenseur (150-1, 150-2) pour prendre et/ou déposer les composants dans une position de pose de la tête de pose (100-1, 100-2) et le préhenseur étant situé dans une zone marginale de la tête de pose (100-1, 100-2) de manière telle que, dans une projection de la tête de pose (100-1, 100-2) sur le plan de pose (BE) l'image du préhenseur (150-1, 150-2) qui se trouve en position de pose ne fait pas saillie par rapport à l'image de la tête de pose (100-1, 100-2), les têtes de pose (100-1, 100-2) pouvant être déplacées simultanément jusqu'à la limite de leur première plage de mouvement respective (I, III), de manière que le plan de pose (BE) peut être équipé simultanément par les têtes de pose (100-1, 100-2) sans risque de collision dans les premières plages de mouvement (I, III) pendant le fonctionnement, **caractérisé en ce qu'**est prévue, de manière adjacente aux premières plages de mouvement (I, III) des têtes de pose (100-1, 100-2), une deuxième plage de mouvement (II) dont la largeur correspond au diamètre d'un préhenseur (150-1, 150-2) et dans laquelle le plan de pose (BE) peut être équipé séquentiellement par les têtes de pose (100-1, 100-2) pendant le fonctionnement, et les premières plages de mouvement (I, III) recouvrant ensemble avec la deuxième plage de mouvement (II) le plan de pose (BE) sur toute sa surface.

2. Système de pose selon la revendication 1, la deuxième plage de mouvement (II) étant située entre les premières plages de mouvement (I, III).

3. Système de pose selon la revendication 2, les préhenseurs (150-1, 150-2) étant placés en principe avec symétrie de rotation sur la tête de pose (100-1, 100-2) et l'axe de rotation des préhenseurs (150-1, 150-2) placés avec symétrie de rotation étant oblique par rapport au plan de pose (BE) de l'automate de pose.

4. Système de pose selon la revendication 2 ou 3, **caractérisé en ce que** la tête de pose (100-1, 100-2) est réalisée en forme de tête revolver.
